# FASCICULE DE BREVET EUROPEEN

(11) **EP 3 685 444 B1**
(45) Date de publication et mention de la délivrance du brevet: **01.06.2022**
(21) Numéro de dépôt: 18769730.5
(22) Date de dépôt: 20.09.2018
(51) Int. Cl.: H01L 31/02

(54) **DISPOSITIF DE DETECTION ET DE LOCALISATION COMPRENANT UNE PLURALITE DE PHOTODIODES**
ORTUNGS- UND DETEKTIONSVORRICHTUNG MIT MEHREREN FOTODIODEN
LOCATING AND DETECTING DEVICE COMPRISING A PLURALITY OF PHOTODIODES

(30) Priorité: 21.09.2017 FR 1700968
(43) Date de publication de la demande: 29.07.2020
(73) Titulaire: Safran Electronics & Defense, 92100 Boulogne-Billancourt (FR)
(72) Inventeur: DAVENEL, Arnaud, 77550 MOISSY-CRAMAYEL (FR); JOUFFROY, Michel, 77550 MOISSY-CRAMAYEL (FR); CHOPIN, Landry, 77550 MOISSY-CRAMAYEL (FR); FRAYSSE, Vincent, 77550 MOISSY-CRAMAYEL (FR)
(74) Mandataire: Lavialle, Bruno François Stéphane
(86) Numéro de dépôt international: PCT/EP2018/075509
(87) Numéro de publication internationale: WO 2019/057834

(56) Documents cités:
- GB-A- 2 447 264
- US-A1- 2012 217 386
- US-A1- 2014 268 116

## Description

La présente invention concerne le domaine de la détection optique et plus particulièrement la détection de taches lumineuses réfléchies ou émises par des objets en vue de leur positionnement dans l'espace.

### ETAT DE LA TECHNIQUE

Il est connu un dispositif de détection et de localisation comprenant un capteur optique comportant quatre photodiodes qui fournissent un signal proportionnel à une quantité d'énergie lumineuse reçue et qui ont des champs se combinant pour former le champ du capteur. On distinguera le champ total du capteur qui est le champ optique dans lequel une tache lumineuse peut être détectée par au moins une des photodiodes et le champ linéaire qui est la partie du champ total dans laquelle plusieurs photodiodes observent la tache lumineuse autorisant ainsi une mesure d'écartométrie. Le dispositif de détection et de localisation est associé à un circuit de calcul agencé pour effectuer une mesure d'écartométrie, c'est-à-dire déterminer la position d'une tache lumineuse se trouvant dans le champ linéaire du capteur en calculant un barycentre de la tache lumineuse dans le champ linéaire du capteur à partir des énergies détectées par les photodiodes. En effet :
- lorsque la tache lumineuse est au centre du champ du capteur, les quatre photodiodes vont mesurer la même énergie lumineuse de sorte qu'elles fournissent des signaux de même valeur, au bruit de mesure près. Le barycentre calculé se trouve donc lui aussi au centre du champ linéaire ;
- si la tache est décalée vers une des photodiodes, ladite photodiode fournira un signal plus important que les autres photodiodes et le barycentre calculé de la tache détectée se trouvera déplacé vers ladite photodiode.

Ce type de dispositif de détection et de localisation est utilisé par exemple pour guider un véhicule en direction d'une tache lumineuse provenant d'un objet.

Le document GB2447264 décrit un dispositif de détection et de localisation comprenant quatre capteurs, chaque capteur étant composé d'une pluralité de photodiodes.

### OBJET DE L'INVENTION

Un but de l'invention est de fournir un moyen pour améliorer les performances d'un tel dispositif de détection et de localisation.

### BREF EXPOSE DE L'INVENTION

A cet effet, on prévoit, selon l'invention, un dispositif de détection et de localisation tel défini par l'objet de la revendication 1, comprenant plusieurs capteurs optiques ayant des champs qui se cumulent pour définir le champ du dispositif de détection et de localisation, chaque capteur comportant une pluralité de photodiodes ayant des champs qui se cumulent pour définir le champ du capteur, les capteurs étant reliés à une unité de commande de telle manière que chaque capteur fournisse un premier signal correspondant à la somme d'au moins deux des signaux des photodiodes .

Quand chaque photodiode produit un signal relativement faible, en sommant les signaux de plusieurs photodiodes, on obtient un signal plus fort mais le bruit reste sensiblement le même de sorte que le rapport signal / bruit est augmenté.

D'autres caractéristiques et avantages de l'invention ressortiront à la lecture de la description qui suit de modes de réalisation particuliers non limitatifs de l'invention.

### BREVE DESCRIPTION DES FIGURES

Il sera fait référence aux dessins annexés, parmi lesquels :
- la figure 1 est une vue schématique en perspective d'un dispositif de détection et de localisation selon l'invention ;
- la figure 2 est une vue schématique du circuit électronique de ce dispositif de détection et de localisation avec les capteurs vus de face ;
- la figure 3 est une vue analogue à la figure 2 d'un seul de ces capteurs selon une variante de réalisation.

### DESCRIPTION DETAILLEE DE L'INVENTION

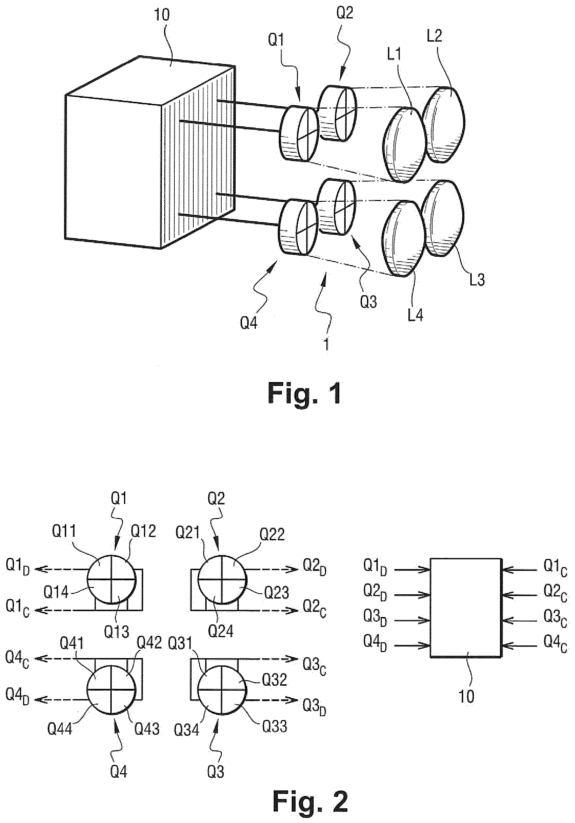

En référence aux figures 1 et 2, le dispositif de détection et de localisation 1 comprend quatre capteurs optiques généralement désignés en Q1, Q2, Q3, Q4 ayant des champs qui se cumulent pour définir le champ du dispositif de détection et de localisation 1, et une unité de commande 10 reliée aux capteurs Q1, Q2, Q3 et Q4.

Chaque voie optique comporte un capteur (Q1, Q2, Q3 ou Q4) comportant quatre photodiodes agencées en quadrants (et symbolisées chacune sous la forme d'un quart de disque pour plus de clarté des figures) et un groupe optique définissant le champ de chaque voie optique qui se combine avec le champ des autres voies optique du même capteur pour définir le champ du capteur en question. Les groupes optiques sont ici symbolisés en L1, L2, L3, L4. Les photodiodes sont ici des monophotodiodes et sont référencées Qi1, Qi2, Qi3 et Qi4 avec i correspondant au numéro du capteur.

Trois des photodiodes de chaque capteur Q1, Q2, Q3, Q4 sont reliées à une ligne collectrice Q1c, Q2c, Q3c, Q4c connectée à l'unité de commande 10 et la dernière photodiode du capteur Q1, Q2, Q3, Q4 est reliée directement à l'unité de commande 10 par une ligne Qld, Q2d, Q3d, Q4d respectivement.

On notera que la photodiode raccordée directement à l'unité de commande 10 n'est pas la même pour les quatre capteurs Q1, Q2, Q3, Q4.

Plus précisément ici :
- les photodiodes Q12, Q13 et Q14 sont reliées à la ligne collectrice Q1c ;
- les photodiodes Q21, Q23 et Q24 sont reliées à la ligne collectrice Q2c ;
- les photodiodes Q31, Q32 et Q34 sont reliées à la ligne collectrice Q3c ;
- les photodiodes Q41, Q42 et Q43 sont reliées à la ligne collectrice Q4c.

Ainsi, chaque capteur Q1, Q2, Q3, Q4 fournit à l'unité de commande 10 un premier signal correspondant à la somme des signaux des trois photodiodes reliées à la ligne collectrice Q1c, Q2c, Q3c, Q4c et un deuxième signal correspondant au signal de la photodiode reliée à ligne Q1d, Q2d, Q3d, Q4d. Le premier signal est donc la somme analogique des signaux des trois photodiodes reliées à la ligne collectrice Q1c, Q2c, Q3c, Q4c.

L'unité de commande 10 comprend une carte électronique comportant de façon connue en elle-même un processeur et une mémoire contenant un programme de commande du dispositif de détection et de localisation 1.

L'unité de commande 10 est programmée pour, d'une part, soustraire le deuxième signal du premier signal de chaque capteur Q1, Q2, Q3, Q4 et, d'autre part, sommer le premier signal et le deuxième signal de chaque capteur Q1, Q2, Q3, Q4.

Le signal résultant de la soustraction est utilisé pour réaliser la mesure d'écartométrie. Le premier signal et le deuxième signal sont affectés d'un bruit identique mais la composante utile du deuxième signal est relativement faible par rapport à celle du premier signal. La soustraction du deuxième signal vis-à-vis du premier signal permet donc, de manière simple, de réduire le bruit sans trop réduire la composante utile du premier signal.

Le signal résultant de la sommation est utilisé pour améliorer le rapport signal/bruit et pour la mesure d'écartométrie.

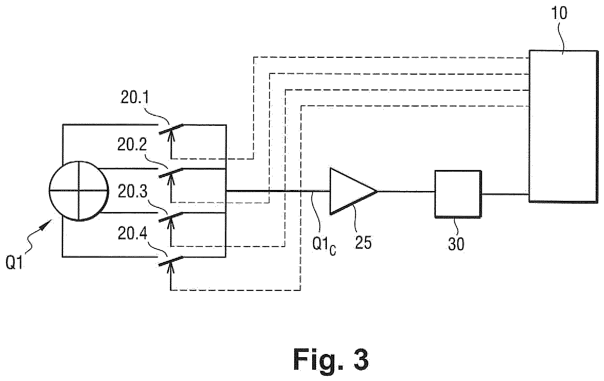

Dans la variante de la figure 3, les photodiodes de chaque capteur Q1, Q2, Q3, Q4 sont reliées entre elles par des commutateurs 20.1, 20.2, 20.3, 20.4 de manière à pouvoir relier n'importe quelles photodiodes d'un même capteur Q1, Q2, Q3, Q4 entre elles et à la ligne collectrice Q1c, Q2c, Q3c, Q4c. La ligne collectrice Q1c, Q2c, Q3c, Q4c est relié à l'unité de commande 10 via un amplificateur 25 et un convertisseur analogique numérique 30.

L'unité de commande 10 est agencée pour changer les photodiodes fournissant le premier signal et le deuxième signal. Plus précisément, l'unité de commande 10 est agencée pour effectuer périodiquement un changement par permutation circulaire des photodiodes et pour filtrer les mesures obtenues. Le filtrage est par exemple un moyennage qui va permettre d'éliminer les erreurs dans les signaux issus du moyennage.

La permutation circulaire est de préférence réalisée après la détection d'une tache lumineuse (comme une impulsion laser).

Ainsi, à titre d'exemple, l'unité de commande 10 est programmée pour que
- à une impulsion p :
   - les photodiodes Q12, Q13 et Q14 soient reliées à la ligne collectrice Q1c ;
   - les photodiodes Q21, Q23 et Q24 soient reliées à la ligne collectrice Q2c ;
   - les photodiodes Q31, Q32 et Q34 soient reliées à la ligne collectrice Q3c ;
   - les photodiodes Q41, Q42 et Q43 soient reliées à la ligne collectrice Q4c ;
- à une impulsion p+1 :
   - les photodiodes Q11, Q13 et Q14 soient reliées à la ligne collectrice Q1c ;
   - les photodiodes Q21, Q22 et Q24 soient reliées à la ligne collectrice Q2c ;
   - les photodiodes Q31, Q32 et Q33 soient reliées à la ligne collectrice Q3c ;
   - les photodiodes Q42, Q43 et Q44 soient reliées à la ligne collectrice Q4c ;
- à une impulsion p+2 :
   - les photodiodes Q11, Q12, et Q14 soient reliées à la ligne collectrice Qlc ;
   - les photodiodes Q21, Q22 et Q23 soient reliées à la ligne collectrice Q2c ;
   - les photodiodes Q32, Q33 et Q34 soient reliées à la ligne collectrice Q3c ;
   - les photodiodes Q41, Q43 et Q44 soient reliées à la ligne collectrice Q4c ;
- à une impulsion p+3 :
   - les photodiodes Q11, Q12 et Q13 soient reliées à la ligne collectrice Q1c ;
   - les photodiodes Q22, Q23 et Q24 soient reliées à la ligne collectrice Q2c ;
   - les photodiodes Q31, Q33 et Q34 soient reliées à la ligne collectrice Q3c ;
   - les photodiodes Q41, Q42 et Q44 soient reliées à la ligne collectrice Q4c.

Le filtrage des pesées opéré pendant ce calibrage tournant permet de réduire les erreurs de sensibilité des seize photodiodes et de leur électronique qui résulteraient du vieillissement des photodiodes (par exemple à cause d'une oxydation) ou d'une évolution du gain analogique ou gain de conversion photo-électrique (évolution de la polarisation ou de l'étage d'alimentation relié au capteur). Ceci est avantageux car ces erreurs ont tendance à évoluer avec le temps ou la température de sorte qu'elles ne peuvent être corrigées une fois pour toute.

Le calibrage tournant peut être réalisé pendant que le véhicule portant le dispositif de détection et de localisation se déplace ou alors lorsque celui-ci est arrêté.

Bien entendu, l'invention n'est pas limitée aux modes de réalisation décrits mais englobe toute variante entrant dans le champ de l'invention telle que définie par les revendications.

En particulier, le dispositif peut avoir une structure différente de celle décrite.

Notamment, le nombre de photodiodes peut être différent de quatre et elles peuvent être agencées différemment. Le dispositif peut par exemple comprendre huit photodiodes disposées en matrice.

En variante, il est possible, dans une version dégradée du premier mode de réalisation de l'invention, de négliger le deuxième signal.

Des filtrages autres que le moyennage sont envisageables.

Un amplificateur peut être monté en sortie de chaque photodiode avant les commutateurs 20.1, 20.2, 20.3, 20.4.

La sommation peut être réalisée de manière analogique ou numérique.

Il est envisageable que le premier signal soit, dans certaines circonstances, égal à la somme des signaux de toutes les photodiodes.

En variante, les photodiodes (Qi1, Qi2, Qi3, Qi4) produisant le premier signal sont connectées les unes aux autres de manière définitive.

## Revendications

1. Dispositif de détection et de localisation comprenant plusieurs capteurs optiques (Q1, Q2, Q3, Q4) ayant des champs qui se cumulent pour définir le champ du dispositif de détection et de localisation, chaque capteur comportant une pluralité de photodiodes (Qil, Qi2, Qi3, Qi4) ayant des champs qui se cumulent pour définir le champ du capteur, les capteurs étant reliés à une unité de commande (10) de telle manière que chaque capteur fournisse un premier signal correspondant à la somme des signaux d'au moins deux des photodiodes, **caractérisé en ce que** le premier signal correspond à la somme des signaux des photodiodes (Qi1, Qi2, Qi3, Qi4) moins une, chaque capteur fournissant un deuxième signal formé par le signal de la photodiode (Qi1, Qi2, Qi3, Qi4) non prise en compte pour le premier signal, dans lequel l'unité de commande (10) est agencée pour soustraire le deuxième signal du premier signal de chaque capteur (Q1, Q2, Q3, Q4).

2. Dispositif selon la revendication 1, dans lequel l'unité de commande (10) est agencée pour sommer le premier signal et le deuxième signal de chaque capteur (Q1, Q2, Q3, Q4).

3. Dispositif selon l'une quelconque des revendications précédentes, dans lequel les photodiodes (Qi1, Qi2, Qi3, Qi4) produisant le premier signal sont connectées les unes aux autres de manière définitive.

4. Dispositif selon l'une quelconque des revendications 1 à 2 dans lequel les photodiodes (Qi1, Qi2, Qi3, Qi4) de chaque capteur sont reliées entre elles par des commutateurs (20.1, 20.2, 20.3, 20.4) de manière à pouvoir relier n'importe quelles photodiodes (Qi1, Qi2, Qi3, Qi4) entre elles, et les commutateurs sont reliés à l'unité de commande (10) pour être pilotés par celle-ci.

5. Dispositif selon la revendication 4, dans lequel l'unité de commande (10) est agencée pour piloter les commutateurs de manière à changer les photodiodes (Qi1, Qi2, Qi3, Qi4) fournissant le premier signal.

6. Dispositif selon l'une quelconque des revendications 4 et 5, dans lequel l'unité de commande (10) est agencée pour effectuer périodiquement un changement par permutation des photodiodes (Qi1, Qi2, Qi3, Qi4) et pour filtrer les mesures obtenues.

7. Dispositif selon l'une quelconque des revendications précédentes, dans lequel les photodiodes (Qi1, Qi2, Qi3, Qi4) sont au nombre de quatre pour chaque capteur (Q1, Q2, Q3, Q4).

## Patentansprüche

1. Ortungs- und Detektionsvorrichtung mit mehreren optischen Sensoren (Q1, Q2, Q3, Q4), die Felder haben, die sich kumulieren, um das Feld der Ortungs- und Detektionsvorrichtung zu definieren, wobei jeder Sensor eine Vielzahl von Photodioden (Qi1, Qi2, Qi3, Qi4) umfasst, die Felder haben, die sich kumulieren, um das Feld des Sensors zu definieren, wobei die Sensoren derart mit einer Steuereinheit (10) verbunden sind, dass jeder Sensor ein erstes Signal liefert, das der Summe der Signale von mindestens zwei der Photodioden entspricht, **dadurch gekennzeichnet, dass** das erste Signal der Summe der Signale der Photodioden (Qi1, Qi2, Qi3, Qi4) weniger eine entspricht, wobei jeder Sensor ein zweites Signal liefert, das durch das Signal der Photodiode (Qi1, Qi2, Qi3, Qi4) gebildet wird, die nicht für das erste Signal berücksichtigt wird, wobei die Steuereinheit (10) ausgebildet ist, um das zweite Signal vom ersten Signal jedes Sensors (Q1, Q2, Q3, Q4) abzuziehen.

2. Vorrichtung nach Anspruch 1, bei der die Steuereinheit (10) ausgebildet ist, um das erste Signal und das zweite Signal jedes Sensors (Q1, Q2, Q3, Q4) zu summieren.

3. Vorrichtung nach einem der vorhergehenden Ansprüche, bei der die Photodioden (Qi1, Qi2, Qi3, Qi4), die das erste Signal erzeugen, miteinander dauerhaft verbunden sind.

4. Vorrichtung nach einem der Ansprüche 1 bis 2, bei der die Photodioden (Qi1, Qi2, Qi3, Qi4) jedes Sensors miteinander über Schalter (20.1, 20.2, 20.3, 20.4) verbunden sind, sodass beliebige Photodioden (Qi1, Qi2, Qi3, Qi4) miteinander verbunden werden können, und die Schalter mit der Steuereinheit (10) verbunden sind, um durch diese gesteuert zu werden.

5. Vorrichtung nach Anspruch 4, bei der die Steuereinheit (10) ausgebildet ist, um die Schalter derart zu steuern, dass die Photodioden (Qi1, Qi2, Qi3, Qi4), die das erste Signal liefern, gewechselt werden.

6. Vorrichtung nach einem der Ansprüche 4 und 5, bei der die Steuereinheit (10) ausgebildet ist, um in regelmäßigen Zeitabständen einen Wechsel durch Vertauschen der Photodioden (Qi1, Qi2, Qi3, Qi4) durchzuführen und um die erhaltenen Messungen zu filtern.

7. Vorrichtung nach einem der vorhergehenden Ansprüche, bei der die Photodioden (Qi1, Qi2, Qi3, Qi4) vier an der Zahl für jeden Sensor (Q1, Q2, Q3, Q4) sind.

## Claims

1. A detection and locating device comprising a plurality of optical sensors (Q1, Q2, Q3, Q4) having fields that together define the field of the detection and locating device, each sensor having a plurality of photodiodes (Qi1, Qi2, Qi3, Qi4) having fields that together define the field of the sensor, the sensors being connected to a control unit (10) in such a manner that each sensor supplies a first signal corresponding to the sum of the signals from at least two of the photodiodes, the first signal corresponding to the sum of the signals from all of the photodiodes (Qi1, Qi2, Qi3, Qi4) minus one, and each sensor supplies a second signal formed by the signal from the photodiode (Qi1, Qi2, Qi3, Qi4) not taken into account for forming the first signal, wherein the control unit (10) is arranged to subtract the second signal of each sensor (Q1, Q2, Q3, Q4) from its first signal.

2. A device according to claim 1, wherein the control unit (10) is arranged to sum the first and second signals of each sensor (Q1, Q2, Q3, Q4).

3. A device according to any preceding claim, wherein the photodiodes (Qi1, Qi2, Qi3, Qi4) that produce the first signal are connected to one another in permanent manner.

4. A device according to any one of claims 1 to 3, wherein the photodiodes (Qi1, Qi2, Qi3, Qi4) of each sensor are connected to one another by switches (20.1, 20.2, 20.3, 20.4) in such a manner as to be able to connect any of the photodiodes (Qi1, Qi2, Qi3, Qi4) together, and the switches are connected to the control unit (10) so as to be controlled thereby.

5. A device according to claim 4, wherein the control unit (10) is arranged to control the switches in such a manner as to change the photodiodes (Qi1, Qi2, Qi3, Qi4) that supply the first signal.

6. A device according to claim 4 or claim 5, wherein the control unit (10) is arranged to change the photodiodes (Qi1, Qi2, Qi3, Qi4) periodically in permutation and to filter the measurements obtained.

7. A device according to any preceding claim, wherein the photodiodes (Qi1, Qi2, Qi3, Qi4) are four in number for each sensor (Q1, Q2, Q3, Q4).
